Europäisches Patentamt

European Patent Office

Office européen des brevets

(11) Publication number : **0 491 567 A1**

# EUROPEAN PATENT APPLICATION

(21) Application number : **91311771.9**

(22) Date of filing : **18.12.91**

(51) Int. Cl.⁵ : **H01L 27/118,** G01P 15/08, G01L 9/00

(30) Priority : **19.12.90 US 631297**

(43) Date of publication of application :
**24.06.92 Bulletin 92/26**

(84) Designated Contracting States :
**DE FR GB**

(71) Applicant : **HONEYWELL INC.**
Honeywell Plaza
Minneapolis Minnesota 55408 (US)

(72) Inventor : **Haviland, Jeffrey S.**
110 Pineview Lane
Plymouth, Minnesota 55441 (US)

(74) Representative : **Fox-Male, Nicholas Vincent
Humbert**
Honeywell Control Systems Limited Charles
Square
Bracknell Berkshire RG12 1EB (GB)

(54) Integrated sensor assembly.

(57)   A method of making an integrated sensor is
described wherein semiconductor array proces-
sing steps are performed on a circuit area of a
silicon substrate to form a partially completed
integrated sensor assembly. Following selec-
tion of a sensor from among a variety of sensor
types, semiconductor processing steps from
the sensor in a separate sensor area of the
substrate, complete the array and interconnect
the sensor with the array.

Fig. 1

EP 0 491 567 A1

## BACKGROUND OF THE INVENTION

The invention disclosed herein relates generally to sensors and more specifically to sensors manufactured through the use of semiconductor process technologies. Sensors of this type, which include the signal and/or data processing electronics, are referred to as integrated sensors or smart sensors. Integrated sensors designed and developed to sense a specific condition are referred to as custom integrated sensors.

In the past, custom integrated sensors of reasonable complexity have required a long development time and have had an attendant high cost. Further, custom designs involve significant risk because unproven circuit designs will have been designed into the custom integrated sensor.

The integration of the design process for the sensor processing electronics with the design process for the sensor to produce a custom integrated sensor causes the long development time, high cost and significant risk. Design times greater than one year and investments in excess of one million dollars are usual in a custom integrated sensor development.

In addition, the custom integrated sensor design process does not easily accommodate changing needs that are discovered during the design cycle, i.e., it is difficult or impossible to go back and make a change made necessary by information learned during the design process. Further, a method is needed that allows development of a prototype integrated sensor in a reduced time and at a reduced cost.

Thus a need exists for an approach to the integrated sensor design and development process that shortens the design time, allows the development of a prototype integrated sensor, and reduces the risk associated with the development of custom integrated sensors.

## SUMMARY OF THE INVENTION

The present invention solves these and other needs by providing a method of manufacturing an integrated sensor by applying semicustom integrated circuit array techniques to the problem of sensor design. It addresses reducing the length of the design time, providing a method that allows economical changes during the design cycle and reducing the overall risk in integrated sensor design. The preferred method includes performing semiconductor array processing steps on the circuit area of a silicon substrate. On the same substrate a sensor area is reserved for later formation of a sensor selected from a variety of possible sensors. The array processing steps continue up to an emitter drive step for bipolar, or other appropriate process step for other semiconductor technologies, at which time the partially completed integrated sensor assembly is placed in inventory.

When the desired sensor type and appropriate circuitry is selected, the semiconductor processing steps are continued to complete the array, form the sensor and interconnect the array and the sensor. The type of sensor selected determines the subsequent semiconductor processing steps.

## BRIEF DESCRIPTION OF THE DRAWINGS

Fig. 1 is a partial top view of an integrated sensor in accordance with applicants' invention.

Fig. 2 is a cross sectional view of the integrated sensor of Fig. 1 along section line 2-2.

Fig. 3 is a partial top view of the sensor area that diagrammatically illustrates a relative humidity sensor.

Fig. 3a is a cross sectional view of the relative humidity sensor along section line 3a-3a.

Fig. 4 is a partial top view of the sensor area that diagrammatically illustrates a thermal conductivity vacuum sensor.

Fig. 4a is a cross sectional view of the thermal conductivity vacuum sensor along section line 4a-4a.

Fig. 5 is a partial top view of the sensor area that diagrammatically illustrates a piezoresistive polysilicon pressure sensor and backside diaphragm.

Fig. 5a is a cross sectional view of the pressure sensor along section line 5a-5a.

Fig. 6 is a partial top view of the sensor area that diagrammatically illustrates a singly supported silicon beam accelerometer using piezoresistive polysilicon strain gauge sensors.

Fig. 6a is a cross sectional view of the beam accelerometer along section line 6a-6a.

Fig. 7 is a partial top view of the sensor area that diagrammatically illustrates a thin film magnetometer.

Fig. 7a is a cross sectional view of the magnetometer along section line 7a-7a.

Fig. 8 is a partial top view of a buried piezoresistive pressure sensor and backside diaphragm.

Fig. 8a is a cross sectional view of the pressure sensor of Fig. 8 along section line 8a-8a.

## DESCRIPTION OF THE PREFERRED EMBODIMENT

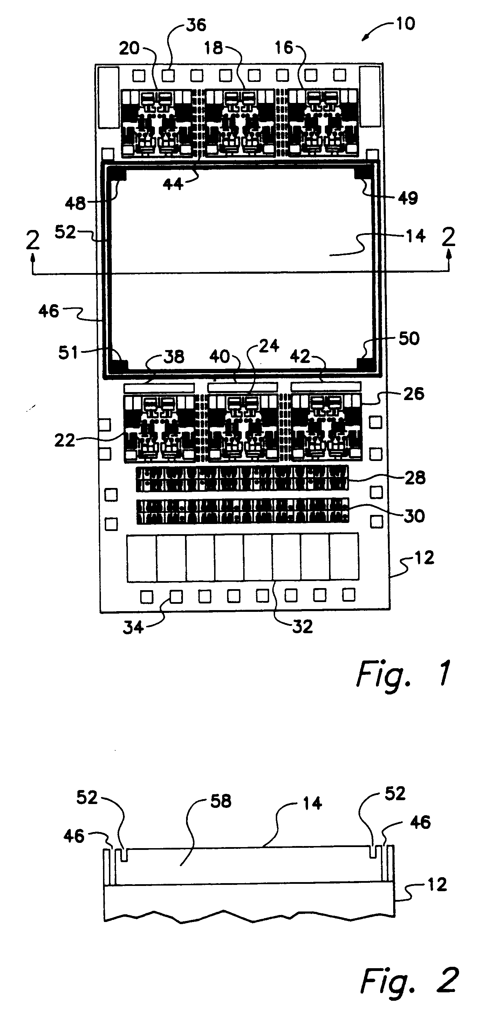

In Figures 1-7, reference numeral 10 identifies an integral transducer or sensor and circuitry in accordance with applicant's invention. As shown in the figures, device 10 includes a silicon die 12, various areas of circuitry, and sensor area 14.

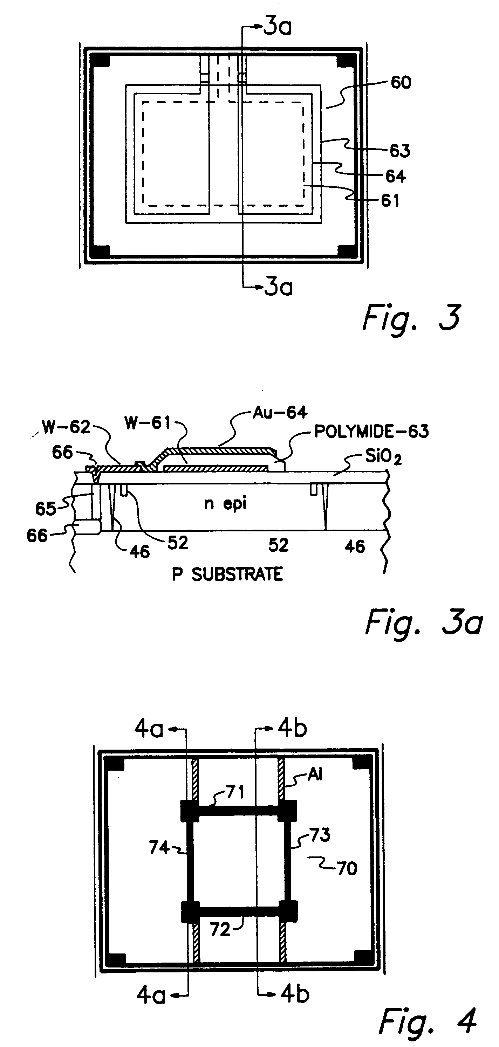

Fig. 1 illustrates the various areas of circuitry with sensor area 14 shown with no sensor present for purposes of illustration. By way of example, but not by way of limitation, various types of sensors that may be located in sensor area 14 are illustrated in Figs. 3-8.

Applicant's invention is directed toward using the same underlayer mask set in the fabrication of a partially completed integrated sensor assembly which is held in inventory. When a desired sensor type is determined the partially completed integrated sensor assembly is withdrawn from inventory and is further processed.

For purposes of illustration the two types of sensor materials considered herein are Low temperature processed sensor materials (such as polyimide, PMMA, and Permalloy), and high temperature processed sensor materials (such as polysilicon or platinum).

The low deposition temperature sensor materials should be deposited after metalization where practical. Compatibility issues must be addressed, as moderate temperature (450°C) annealing must be performed to the aluminum. If the sensor material cannot withstand this, the sensor deposition must come as one of the final steps. Contact to the aluminum must also be considered, as well as passivation requirements.

The high temperature materials, i.e., those that would be deposited above approximately 400°C, must be deposited prior to metalization, and the time and temperature of their deposition and anneal must be used to re-calculate emitter drive time. The remaining emitter drive time must also be considered when assessing temperature affects on the sensor material.

The embodiment shown has six analog circuit cells 16, 18, 20, 22, 24 and 26 which may also be referred to as analog tiles or analog blocks. These types of analog circuit cells or processing arrays are available from a variety of manufacturers, and may include, for example, a family of bipolar analog arrays. An analog array may include features such as large value thin film resistors, lateral and vertical PNP transistors, MOSCAP capacitors, variable $\frac{W}{L}$ JFET transistors, two types of implanted resistors and several sizes of NPN transistors.

Digital processing circuitry or logic circuits are shown as 28 and 30. These type arrays are also available from several manufacturers. In the embodiment shown, 165 equivalent digital gates are provided. These are arranged in a 55 x 3 array.

In the embodiment shown, a series of eight transistor-transistor (TTL) - current mode logic (CML) input/output (I/O) buffers are provided on the lower portion of die 12. TTL-CML I/O buffer 32 is shown as typical. These digital buffer cells are for use in interfacing to the CML logic with TTL external signal levels.

Input/output pads are provided at the perimeter of die 12. Pads 34 and 36 are shown as typical.

Additional active circuit devices not included in the array cells are provided at 38, 40 and 42.

Programmable resistors in addition to those on the analog tiles are provided. For example, thin film CrSi resistors 44 are located between analog cells 18 and 20.

The foregoing description of the various circuitry on substrate 12 is intended as illustrative. Different combinations of analog array components, digital array components, input/output buffers, input/output pads, programmable resistors and other elements or components may be provided and still be within the scope of the present invention.

Turning now to sensor area 14, sinkers 48, 49, 50 and 51 are of highly doped n-type material in order to make good contact down to the electrical tub in which various active sensor devices may be built. Sinkers 48, 49, 50 and 51 are connected together by a ring 52 of gate implant which surround sensor area 14. Gate implant ring 52 is further surrounded by a ring of isolation 46.

A power buss arrangement extends around the perimeter of sensor area 14 and is available for use.

Integrated sensor array 10 has now been generally described without discussing the details of any specific sensor type that may be selected for formation in sensor area 14. Up until the time that a sensor type is selected and processing of the sensor begins, sensor area 14 contains only a layer of oxide 58 on substrate 12 as illustrated in Fig. 2.

In general, the fabrication of analog and digital processing components will proceed to a specific stage before sensor fabrication is begun. The wafer fabrication will proceed up to the emitter drive or other appropriate process step where decisions on the type of sensor will affect subsequent processing. For example, if polysilicon is to be used in the sensor, then because the polysilicon process is a higher temperature process than the wafer metallization can endure, the polysilicon process must be done before the metallization.

In addition, because certain processes used in connection with the sensor fabrication are high temperature processes this must be considered in determining the emitter drive time for junctions on the analog tiles. For example, if polysilicon is to be deposited in the sensor area 14, then the emitter drive time must be shortened since the temperature of the wafer during the polysilicon deposition will be high enough to cause movement of junctions in the signal processing array. This anticipated movement must be planned for when the emitter drive time is calculated.

In accordance with the teachings of the present invention, various types of sensors may be utilized in sensor area 14 and the process of forming the sensor is very dependent on the specific type of sensor desired.

A description of various sensor types and the process for forming the sensor types follows. It is to be understood that the array of sensors described is only illustrative and that the present invention is not limited to the sensor types described herein.

## RELATIVE HUMIDITY SENSOR

Fig. 3 illustrates a sensor in the form of a parallel plate capacitor 60 with the dielectric being a polymer whose dielectric constant changes as a function of its moisture content. The dielectric constant and therefore the capacitance of the capacitor will increase with increasing ambient relative humidity at equilibrium and circuitry can be implemented using well known techniques to sense this capacitance change.

The partially completed integrated sensor assembly which has been completed up to the emitter drive step is withdrawn from inventory. Since the processes associated with the relative humidity sensor are not high temperature processes it will not be necessary to modify the standard emitter drive time and this drive process may be completed without modification.

The wafer containing the partially completed sensor assemblies is then run through a metallization process which leaves metal over the entire surface. The metal is lithographically defined and etched to interconnect the components in the analog and digital arrays. On the sensor area a solid layer of metal 61 is left to form the bottom plate of the capacitor and a runner 62 is left to connect the upper plate, after it is formed, to the circuitry. A tungsten runner (not shown) may be deposited for connection to bottom plate 61. N+ sinker 65 and N+ buried layer 66 provide connection to runner 62 at 66. Next a layer of polyimide 63 or other chosen polymer is deposited. A masking and etching step is then used to leave the polyimide only over bottom plate 61 of the capacitor. This is followed by a very thin layer of gold metallization 64 which is so thin as to be porous to moisture but conductive. An etch step then removes the gold except for a layer of gold forming the upper capacitor plate 64 and also overlying conductive runner 62 from the upper plate to the circuitry that will sense the change in capacitance.

## THERMAL CONDUCTIVITY SENSOR:

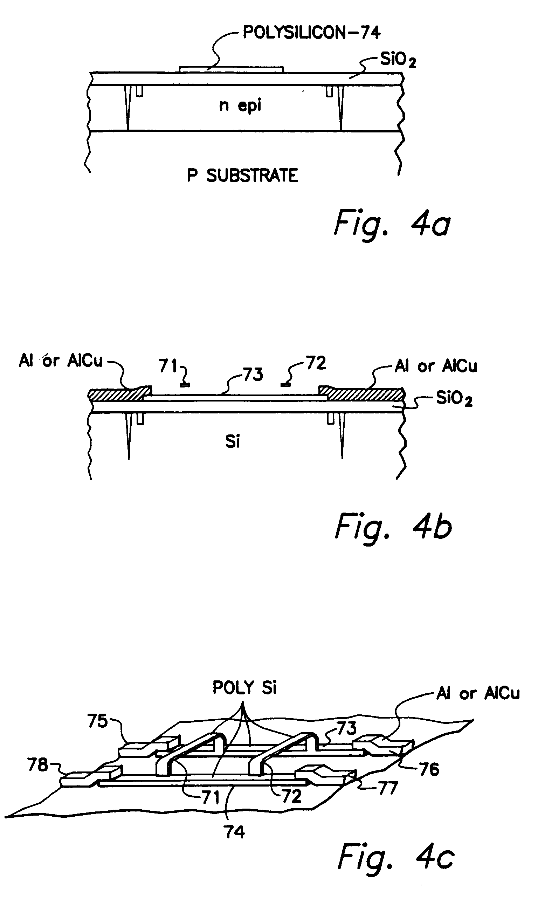

Fig. 4 illustrates a thermal conductivity vacuum sensor or Pirani gauge 70 fabricated out of polysilicon.

Bridge 70 includes raised portions 71 and 72 and surface portions 73 and 74. Electrical connections for bridge input may be made at 75 and 77 with bridge output connections at 76 and 78. Depositions 75, 76, 77 and 78 are of Al or AlCu.

The partially completed integrated sensor assembly which has been completed up to the emitter drive step will be withdrawn from inventory. A calculation of the emitter drive time is made which considers the effect of the polysilicon process.

Following the shortened emitter drive step, a layer of CVD oxide is deposited and etched, then the polysilicon is deposited.

Following the polysilicon deposition and etch, the assembly is run through the metallization process which leaves a layer of metal over the entire assembly. Next the metal layer is lithographically defined and etched to interconnect the array components and the temperature dependent resistors.

Then the aluminum and the polysilicon are masked and the CVD oxide is etched from beneath selected areas of polysilicon, leaving free-standing, thermally isolated, temperature dependent polysilicon resistors 73 and 72 which with resistors 73 and 74 form the Pirani Gauge sensor.

## POLYSILICON PRESSURE SENSOR:

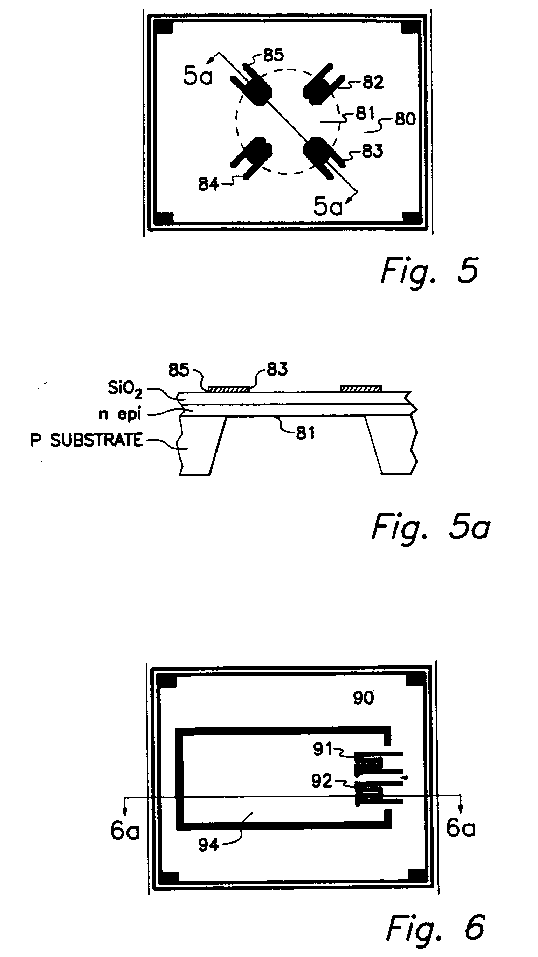

Fig. 5 illustrates an integrated pressure sensor 80 using four piezoresistive polysilicon resistors at the edges of diaphragm 81: Resistors 82, 83, 84, and 85 would be connected into a full Wheatstone bridge configuration. The Wheatstone bridge would have a voltage applied at opposite nodes and the bridge output would be sensed at the remaining opposite nodes. No such circuit interconnections are shown.

The partially completed integrated sensor assembly which has been completed up to the emitter drive step is withdrawn from inventory. A calculation of the emitter drive time is made which considers the effect of the polysilicon process.

Following the emitter drive step the polysilicon is deposited.

Following the polysilicon deposition the assembly is run through the metallization process, then lithographically masked and etched to interconnect the array and the sensor.

Backside etching using well known techniques to form a stress-concentration diaphragm is performed after all other processing.

## POLYSILICON BEAM ACCELEROMETER:

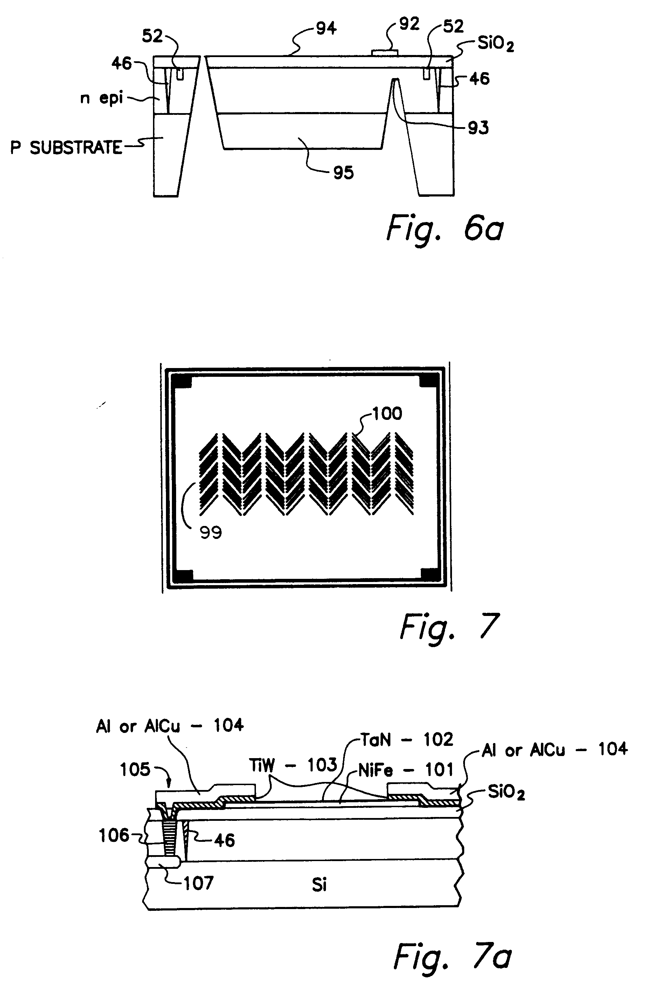

Fig. 6 illustrates a beam accelerometer 90. Mass 95 is carried by beam 90. Using piezoresistive polysilicon strain sensors 91 and 92, acceleration is detected through strain at the root 93 of beam 94. Strain sensors 91 and 92 are connected in a half bridge.

The partially completed integrated sensor assembly which has been completed up to the emitter drive step will be withdrawn from inventory. A calculation of the emitter drive time is made which considers the effect of the planned polysilicon process.

Following the emitter drive step, the polysilicon is deposited.

Next the polysilicon will be masked and etched to form strain sensors 91 and 92.

The next step is to perform metallization to interconnect the array components and strain resistors 91 and 92.

The backside etching to form the beam is performed after all other processing.

## MAGNETOMETER:

Fig. 7 illustrates a thin film magnetometer 100 fabricated from magnetic NiFe (permalloy). Magnetometer 100 operates on the principle of magnetoresistance, i.e., the changing of the resistance value of a long thin strip of NiFe in response to a magnetic field. Magnetometer sensor 100 uses many NiFe series wired resistors 99 in a full Wheatstone bridge configuration.

Magnetometer 100 includes a layer of NiFe (permalloy) 101 covered by a very thin layer of TaN-102. A thin layer of Tantalum Nitride is deposited in situ over the permalloy such that the permalloy is not exposed to the atmosphere during processing, as exposure of the permalloy to air will cause it to oxidize.

Magnetometer 100 further includes TiW-103 which is overlayered by Al or AlCu-104. A typical circuit connection 105 interconnects TiW-103 to N+ sinker 106 and N+ buried layer 107.

The partially completed integrated sensor assembly which has been completed up to the emitter drive step will be withdrawn from inventory. A calculation of the emitter drive time is made which considers the effect of the planned permalloy process.

Following the emitter drive step several processes must be performed without exposing the assembly to air. These processes can be described as follows:

Depositing a layer of magnetoresistive material such as NiFe. A layer of 300-400 angstroms has been successfully used in a working model.

Depositing a layer of TaN over the NiFe. TaN protects the NiFe from oxidation and also has a sufficiently higher resistance than NiFe.

Deposit TiW over the TaN. This improves the adhesion of the metallization.

Deposit AlCu or Al in the metallization step.

Mask and etch the metallization to form interconnections.

Remove the TiW where it is not covered by metallization using a wash process.

Mask and etch the TaN and NiFe to form the herringbone sensor pattern.

## BURIED JUNCTION SENSOR:

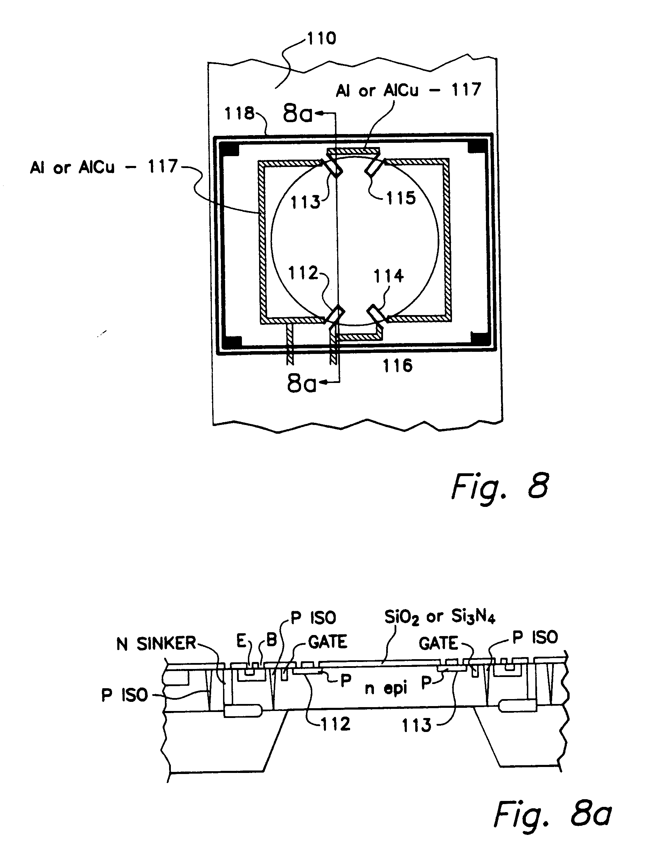

Fig. 8 illustrates an integrated pressure sensor using buried piezoresistors 112, 113, 114, and 115 and diaphragm 116. An isolation ring 117 is shown and Al or AlCu metallization is shown at 117. Buried piezoresistors 112 and 113 are best shown in Fig. 8a. Piezoresistors are formed by either adding the piezoresistor feature to the base layer of the integrated sensor array mask set or by adding the piezoresistor in a separate masking step at a compatible point in the processing. The process for adding the piezoresistor with a separate masking step may be described as follows:

1) Removing the partially completed wafers from inventory;

2) Mask with thick photoresist, then remove resist where the buried piezoresistors are to be formed using an appropriate photomask;

3) Implant with Boron or other suitable P-type dopant to a suitable depth (profile) and resistivity (dose);

4) Remove photoresist, clean wafers and perform emitter drive (or equivalent) step;

5) Deposit metal using either Al or AlCu;

6) Define and etch metal. The buried piezoresistors are connected at this time, to and along with circuit metallization;

7) Passivate front side, mask and etch;

8) Perform necessary back side diaphragm masking & etching.

Applicant has hereinbefore described a number of sensor types. It is understood that there are many more sensor types that some within applicant's invention which have not been described. By way of example but not limitation, sensing metals such a Pt, W, $FeO_2$, $PbTiO_3$ may be used. Further high temperature superconduction materials such as $YBa_2Cu_3O_7$ may be used.

Applicant's invention is directed toward the ability to use the same set of underlayers in the partially completed integrated sensor assembly. These underlayers will generally include approximately the first 10 masks that in the past would have been used in the development of new sensors.

Now that the basic method of making integrated sensor array 10 according to the present invention have been disclosed, many advantages can be further set forth and appreciated. In the past the biggest impediment to the use of smart sensors has been the development time and cost. Integrated sensor array 10 attacks the development time and cost problems directly by applying semicustom integrated technology to smart sensors. Through the use of integrated sensor array 10, sensor manufacturers may greatly reduce the development time and cost for an integrated or smart sensor.

Sensor manufacturers frequently face the need to both determine exactly what configuration of a sensor and supporting circuitry is required and to bring this required sensor product to market in a short time, so as to take advantage of market conditions. Integrated sensor array 10 can help sensor manufacturers both in determining the optimum designs for the sensor product and in bringing the sensor product to market in a short time period.

When the planned sensor product will be a high volume product, integrated sensor array 10 may be used to quickly develop a prototype sensor product at a lower cost. The use of an integrated prototype design will allow the prototype sensor product to undergo testing and have improvements incorporated into it before the final mass produced sensor product is manufactured.

When the planned sensor product will be a low volume product, integrated sensor array 10 may be marketed as the actual final sensor product.

The development time using integrated sensor array 10 will be dramatically reduced because the first weeks or months needed to develop circuits in a custom sensor will not be needed. With integrated sensor array 10, proven circuits are already available in the analog arrays and digital arrays integral to the sensor assembly.

The use of integrated sensor array 10 also allows the user to easily and economically incorporate needed changes that become known during the design process.

The circuits may also be configured to customize the output of device 10 as required. The options include but are not limited to voltage, current, frequency, duty cycle, pulse width, and serial or parallel digital words.

In addition, the circuits may be used to customize the sensor excitation as required. Here the options include but are not limited to constant current, constant voltage, temperature compensated current, temperature compensated voltage, or closed loop voltage or current control.

Also the circuits may be used to customize the amplification gain or filtering. Options include but are not limited to precision transfer function, selective frequency rejection or acceptance, off-chip gain control, off-chip standby power control, or off-chip function selection (such as high sensitivity or low sensitivity).

In accordance with the foregoing description, applicant has developed a method of making an integrated sensor. The method provides for a shorter development time and a lower development cost than custom integrated sensor development. Further the method may be easily incorporated into semiconductor processing steps.

Although a specific embodiment of applicant's method is shown and described for illustrative purposes, a number of variations and modifications will be apparent to those of ordinary skill in the relevant arts. It is not intended that coverage be limited to the disclosed embodiment, but only by the terms of the following claims.

## Claims

1. A method of making an integrated sensor assembly (10) for sensing a condition and performing a function, characterised by:

   providing an integrated circuit substrate (12) having a surface, said surface having a sensor area (14) and a circuit area;

   performing at least initial semiconductor array processing steps in said circuit area to form at least partially completed array components and to provide a partially completed integrated sensor assembly (10) which may be held in inventory;

   subsequently performing semiconductor sensor processing steps on said partially completed integrated sensor assembly (10) to form a sensor on said sensor area (12), said sensor being selected from among a plurality of sensor types;

   continuing said semiconductor array processing steps to provide completed array components; and

   performing semiconductor interconnection processing steps to form interconnection of said completed array components and interconnection of said sensor to said completed array components, said interconnections being dependent on said sensor type and said function.

2. A method according to Claim 1 characterised by said step of continuing said semiconductor array processing steps to form completed array components is completed before said step of performing semiconductor processing steps to form a sensor on said sensor area (14).

3. A method according to Claim 1 or 2 characterised by said step of continuing said semiconductor array processing steps to form completed array components is completed after said step of performing semiconductor processing steps to form a sensor on said sensor area (14).

4. A method according to Claim 1 or 2 characterised in that said at least partially completed array components comprise only partially completed analog array components.

5. A method according to any preceding Claim characterised in that said at least partially completed array components comprise both partially completed analog array components and partially completed digital array components.

6. A method according to any preceding Claim characterised in that said at least initial array processing steps continue up to an emitter drive step.

7. A method according to any preceding Claim characterised in that said step of performing semiconductor processing steps to form a sensor includes the following steps:

depositing polysilicon on said sensor area (14);

performing photolithography and etching steps to define and remove portions of said polysilicon to form a sensor structure within said polysilicon; and

performing photolithography and etching steps to form piezoresistors in said sensor structure.

8. A method according to any preceding Claim characterised in that said sensor area (14) has a backside and said step of performing semiconductor processing steps to form a sensor includes the following steps:

depositing polysilicon on said sensor area (14);

performing photolithography and etching steps to form piezoresistors in said polysilicon;

performing photolithography and etching steps on said backside to form a sensor structure, with said piezoresistors sensing strain in said sensor structure.

9. A method according to Claim 7 or 8 characterised in that said step of performing semiconductor processing steps to form a sensor includes the following steps:

depositing a magnetoresistive material on said sensor area (14);

depositing a protective material over said magnetoresistive material, said protective material having a substantially greater resistance than said magnetoresistive material;

depositing an adhesion improving material over said protective material;

depositing a metalisation material over said adhesion improving material;

masking and etching said metalisation to form interconnections to said magnetoresistive material;

removing the adhesion improving material where it is not covered by said metalisation; and

masking and etching said protective material and said magnetoresistive material to form a sensor.

10. A method according to Claim 9 characterised in that said magnetoresistive material is NiFe; said protective material is TaNi and said adhesion improving material is TiW.

11. A method according to any preceding Claim characterised in that said step of performing semiconductor processing steps to form a sensor includes at least the following steps:

masking said sensor area (14) with photoresist;

removing said photoresist from at least one predetermined area; and

implanting said at least one predetermined area with a dopant to a suitable depth and resistivity to form at least one buried piezoresistor.

12. A method according to Claim 11 characterised in that said sensor area (14) has a backside and said step of performing semiconductor processing steps to form a sensor includes the following steps:

performing photolithography and etching steps on said backside to form a sensor structure with said at least one buried piezoresistor sensing strain in said sensor structure.

13. A method of making an integrated sensor assembly (10) for sensing a condition and performing a function, characterised by:

providing an integrated circuit substrate (12);

performing at least initial array processing steps in a first substrate portion to form at least partially completed array components and to provide a partially completed integrated sensor assembly (10) which may be held in inventory;

subsequently performing semiconductor sensor processing steps in a second substrate portion (14) to form a sensor, said sensor being selected from among a plurality of sensor types; and

performing semiconductor interconnection processes to interconnect said array components and said sensor.

14. A method according to Claim 13 characterised in that said at least partially completed array components comprise only partially completed analog array components.

15. The method of claim 13 wherein said at least partially completed array components comprise both partially completed analog array components and partially completed digital array components.

16. A sensor assembly characterised by manufacture according to the method of any preceding Claim.

Fig. 1

Fig. 2

*Fig. 3*

*Fig. 3a*

*Fig. 4*

POLYSILICON—74

SiO$_2$

n epi

P SUBSTRATE

*Fig. 4a*

Al or AlCu

71 73 72 Al or AlCu

SiO$_2$

Si

*Fig. 4b*

POLY Si

Al or AlCu

75 73

78 76

71 72 77

74

*Fig. 4c*

*Fig. 5*

*Fig. 5a*

*Fig. 6*

*Fig. 6a*

*Fig. 7*

*Fig. 7a*

110

AI or AICu — 117

118

8a

AI or AICu — 117

113

115

112

114

116

8a

*Fig. 8*

P ISO

N SINKER

E

B

GATE

SiO$_2$ or Si$_3$N$_4$

GATE

P ISO

P ISO

P

n epi

P

112

113

*Fig. 8a*

**European Patent Office**

**EUROPEAN SEARCH REPORT**

Application Number

EP 91 31 1771

Page 1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | ELEKTRONIK vol. 37, no. 9, 29 April 1988, MÜNCHEN, W. GERMANY pages 112 - 117; H.A. KAYAL ET AL: 'Anwendungsspezifische intelligente Sensoren ("ASIS")' * page 116, left column, last paragraph - page 117, left column, last paragraph; figures 5,7 * | 1,2,4, 13,14,16 | H01L27/118 G01P15/08 G01L9/00 |
| Y | | 5,7,8, 12,15 | |
| A | | 9,10 | |
| Y | SENSORS AND ACTUATORS vol. 13, no. 1, January 1988, LAUSANNE, SWITZERLAND pages 53 - 62; I. IGARASHI: 'Semi-conductor dynamic sensors' * page 59, last paragraph - page 61, paragraph 1; figure 10 * | 1,2,4, 13,14,16 | |
| A | | 3,5 | |
| Y | PATENT ABSTRACTS OF JAPAN vol. 11, no. 341 (E-554)(2788) 7 November 1987 & JP-A-62 122 234 ( HITACHI LTD ) 3 June 1987 * abstract * | 1,2,4, 13,14,16 | TECHNICAL FIELDS SEARCHED (Int. Cl.5) H01L G01P G01L |
| Y | ELECTRONIC DESIGN vol. 36, no. 23, October 1988, HASBROUCK HEIGHTS, NJ, USA pages 149 - 154; F. GOODENOUGH: 'Mixed-mode arrays give designers options' * the whole document * | 5,15 | |
| Y | EP-A-0 150 827 (HITACHI LTD) * page 8, line 28 - page 9, line 16; figure 4 * | 7,8,12 | |

-/--

The present search report has been drawn up for all claims

| Place of search | Date of completion of the search | Examiner |
|---|---|---|
| THE HAGUE | 01 APRIL 1992 | CHAPPLE I.D. |

European Patent
Office

**EUROPEAN SEARCH REPORT**

Application Number

EP    91 31 1771
Page 2

| Category | Citation of document with indication, where appropriate, of relevant passages | Relevant to claim | CLASSIFICATION OF THE APPLICATION (Int. Cl.5 ) |
|---|---|---|---|
| A | IBM TECHNICAL DISCLOSURE BULLETIN<br>vol. 29, no. 8, January 1987, ARMONK, NY, USA<br>pages 3387 - 3388; 'Masterslice concept for VLSI chips'<br>* the whole document * | 1,13,16 | |
| A | PATENT ABSTRACTS OF JAPAN<br>vol. 6, no. 194 (E-134)(1072) 2 October 1982<br>& JP-A-57 104 284 ( SHARP K.K. ) 29 June 1982<br>* abstract * | 9,10 | |
| | | | **TECHNICAL FIELDS SEARCHED (Int. Cl.5 )** |

The present search report has been drawn up for all claims

| Place of search | Date of completion of the search | Examiner |
|---|---|---|
| THE HAGUE | 01 APRIL 1992 | CHAPPLE I.D. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.................................................................................
& : member of the same patent family, corresponding document

EPO FORM 1503 03.82 (P0401)